(19) **Europäisches Patentamt**

**European Patent Office**

**Office européen des brevets**

(11) **EP 0 794 266 B1**

(12) **EUROPÄISCHE PATENTSCHRIFT**

(45) Veröffentlichungstag und Bekanntmachung des Hinweises auf die Patenterteilung:
**06.12.2000   Patentblatt 2000/49**

(51) Int Cl.7: **C23C 14/28**, C23C 14/30

(21) Anmeldenummer: **96810130.3**

(22) Anmeldetag: **06.03.1996**

(54) **Vorrichtung zum Beschichten einer Substratfläche**

Apparatus for coating a substrate surface

Dispositif de revêtement d'une surface d'un substrat

(84) Benannte Vertragsstaaten:
**BE CH DE DK ES FR GB IE IT LI NL**

(43) Veröffentlichungstag der Anmeldung:
**10.09.1997   Patentblatt 1997/37**

(73) Patentinhaber: **Alusuisse Technology & Management AG**
**8212 Neuhausen am Rheinfall (CH)**

(72) Erfinder:
• **Wisard, André**
**CH-8106 Adlikon (CH)**

• **Lohwasser, Wolfgang**
**D-78262 Gailingen (CH)**

(56) Entgegenhaltungen:
**US-A- 3 552 352**

• **PATENT ABSTRACTS OF JAPAN vol. 95, no. 006, 31.Juli 1995 & JP-A-07 074101 (MATSUSHITA ELECTRIC IND CO LTD), 17.März 1995,**
• **PATENT ABSTRACTS OF JAPAN vol. 95, no. 005, 30.Juni 1995 & JP-A-07 034231 (NEC CORP), 3.Februar 1995,**

**Beschreibung**

Vorliegende Erfindung betrifft eine Vorrichtung enthaltend eine Vakuumkammer und darin angeordnet ein Substrat und ein mit anorganischen Materialien befüllter Verdampfertiegel und eine im Bereich der Vakuumkammer angebrachte Elektronenstrahl- oder Laserkanone, deren Elektronen- oder Laserstrahl auf die Oberfläche der anorganischen Materialien im Verdampfertiegel gerichtet ist, zum Beschichten einer Substratfläche mit einer Überzugsschicht aus anorganischen Materialien durch Verdampfen der anorganischen Materialien. Im weiteren betrifft die Erfindung auch ein Verfahren zum Beschichten einer Substratfläche.

Es ist beispielsweise aus der CH-A 683 776 ein Verfahren bekannt zum Beschichten einer Substratfläche mit einer Permeationssperre aus anorganischem Material, welches in einer z.B. auf wenigstens $10^{-3}$ mbar evakuierten Vakuumkammer aus einem Tiegel verdampft und auf der Substratfläche niedergeschlagen wird.

Die Patentschrift US 3,552,352 offenbart ebenfalls ein Verfahren zum Beschichten einer Substratfläche mit einem anorganischen Material durch Verdampfen des Materials aus einem Tiegel mittels Elektronenstrahl in einer Vakuumkammer. Der Tiegel ist auf einem rotierenden Tisch ortsfest fixiert. Bedingt durch den rotierenden Tiegel, verdampft der Elektronenstrahl in einem kreisförmigen Weg anorganisches Material aus dem Tiegel.

Das thermische Aufdampfen ist das am häufigsten gebrauchte Verfahren für die Herstellung von optischen Beschichtungen. Beispielsweise beim Beschichten von Verpackungsfolien als Substratfläche wurde festgestellt, dass die Verpackungsfolien grössere oder kleinere Mengen von Inhomogenitäten aufweisen. Diese Inhomogenitäten können auch als Spritzer bezeichnet werden. Es wurde beobachtet, dass beim Verdampfen oder Sublimieren des Tiegelinhaltes unter der Einwirkung beispielsweise des Elektronenstrahls kleinste Anteile des Tiegelinhaltes nicht in die Gasphase übergehen, sondern durch Siedeverzüge oder ähnliche lokale Energieanreicherungen in fester oder flüssiger Form als kleinste Partikel oder Tröpfchen aufspritzen und durch die Vakuumkammer teilweise bis auf das Substrat geschleudert werden. Auf dem zu beschichtenden Substrat werden durch diese Partikel oder Tröpfchen Fehlstellen oder gar Beschädigungen hervorgerufen. Auf dem Substrat sind diese Inhomogenitäten, Fehlstellen oder gar Beschädigungen nicht zu tolerieren. Dies trifft ganz besonders dann zu, wenn Kunststoff-Folien für Verpackungszwecke mit anorganischem Material beschichtet werden müssen.

Aufgabe vorliegender Erfindung ist es, eine Vorrichtung mit einem Verfahren vorzuschlagen, welches es ermöglicht, weitestgehend homogene, fehlstellenfreie Beschichtungen und Beschichtungen ohne Beschädigung der Substrate zu erzeugen.

Erfindungsgemäss wird dies dadurch erreicht, dass der Elektronen- oder Laserstrahl und die Oberfläche der anorganischen Materialien einen Winkel $\alpha$ von 10 bis 80° einschliessen und der Verdampfertiegel und die Elektronen- oder Laserstrahlkanone bezüglich ihrer Längsachsen relativ zueinander beweglich sind, wobei sich beim Abdampfen der anorganischen Materialien ein Überhang an anorganischen Materialien ausbildet und geometrisch keine Sichtverbindung von den verdampfenden anorganischen Materialien zur Substratfläche besteht.

Ist das Substrat eine Kunststoff-Folie, so bewirken die auf dem Substrat niedergeschlagenen anorganischen Verbindungen eine wirksame Barriere, beispielsweise gegen Gase, Dämpfe oder eingeschlosse Aromastoffe.

Bevorzugt wird das im Tiegel befindliche anorganische Material durch Beaufschlagung mit einem Elektronenstrahl oder Laserstrahl aus einer scannenden Hochspannungs-Elektronenstrahlkanone oder Laserstrahlkanone verdampft. Unter "scannend" wird hier verstanden, dass der Elektronenstrahl oder Laserstrahl die Oberfläche des zu verdampfenden anorganischen Materials programmgesteuert durch wechselseitiges seitliches Ausschwenken abfährt. Der Elektronen- oder Laserstrahl ist gegenüber dem Verdampfertiegel demnach vorteilhaft seitlich beweglich. Die an einer Elektronenstrahlkanone, z.B. einer Hochspannungs-Elektronenstrahlkanone angelegte Spannung liegt bevorzugt bei wenigstens 5 kV, insbesondere bei wenigstens 10 kV, bei einer Stromstärke von beispielsweise 0,5 bis 10 A. Die Hochspannungs-Elektronenstrahlkanone arbeitet beispielsweise mit einer Spannung von 35 kV.

Zur Abfuhr der elektrostatischen Aufladung kann in der Vakuumkammer eine Anode angeordnet sein. Die Anode kann durch die Vakuumkammer oder Tiegelteile gebildet sein oder kann durch eine andere geeinete Fläche gebildet sein, z.B. ein Rohr, Blech, Profil, Gitter oder Draht. Die Anoden können auch auf Temperaturen, die über den Verdampfungstemperaturen des verdampften Materials liegen, beheizt werden. Falls die Wand der Vakuumkammer gegenüber der Anode isoliert ist, kann mit einer zusätzlichen Spannungsquelle das Potential der Anode angehoben werden, vorzugsweise von 20 - 300 V, was zu einer höheren Potentialdifferenz zwischen Plasma und Substrat führt, was wiederum zu einer höheren Beschleunigung der fallweise ionisierten Materialteilchen führt.

Zusätzlich kann ein ionisierender Elektronenstrahl niedriger Energie, unter Bildung eines Plasmas, durch die Gasphase aus anorganischem Material geleitet werden.

Die bevorzugte Beschichtungsquelle ist ein Elektronenstrahlverdampfer, bei dem ein Tiegel verwendet wird, dessen Länge (z.B. ca. 1 m bis 2,5 m) grösser ist als die Breite (z.B. ca. 0,8 m bis 2,2 m) des an dem Tiegel vorbeigeführten Substrates. Eine oder mehrere Elektronenstrahlkanonen scannen diesen Tiegel ab, wobei Elektronen in den Elektronenstrahlkanonen eine Beschleunigungsspannung von z.B. 5 bis 40 kV durchlaufen. Die pro Meter Tiegel einzubringende Leistung liegt dabei im Bereich von 35 bis 100 kW. Dabei werden auf dem Substrat Niederschlagsraten erzielt, die wenigstens bei 0,01 µm/sec liegen, vorzugsweise jedoch im Bereich von 0,5 - 1 µm/sec. Diese Leistung führt bei einer Substrattransportgeschwindigkeit von ca. 200 m/min z.B. zu einer Schichtdicke von ca. 60 nm.

Das erfindungsgemässe Verfahren kann beispielsweise an feststehenden oder insbesondere an kontinuierlich durchlaufenden Substraten ausgeführt werden.

Die dem Verdampfertiegel zugewandte Substratoberfläche kann gegebenenfalls erst gereinigt und aktiviert werden, um eine weitere Verbesserung der Schichthaftung und deren Widerstandsfähigkeit anzustreben.

Das Reinigen und Aktivieren kann beispielsweise durch eine Plasmavorbehandlung erfolgen.

Bei einem kontinuierlichen Verfahren kann das Substrat aufliegend oder frei geführt werden und mit einer Geschwindigkeit von z.B. 1 bis 10 m/sec und insbesondere 3 bis 6 m/sec durch die Vakuumkammer geführt werden.

Als Substrate sind insbesondere thermoplastische Kunststoffe enthaltende oder daraus bestehende Werkstoffe geeignet.

Die Substrate können als gegossene, extrudierte oder folienförmige Werkstoffe z.B. als Rollenware oder als Bögen vorliegen. Die Werkstoffe können starr, halbstarr oder flexibel sein. Die Werkstoffe können nach dem Beschichten z.B. direkt als Verpackungsmaterial Verwendung finden oder die Substrate können nach dem Beschichten durch laminieren, kaschieren oder durch aufextrudieren etc. weiterer Schichten weiterverarbeitet werden. Bevorzugt wird die aufgedampfte Beschichtung durch eine darüber liegende Schicht, wie eine Folie oder ein Laminat, die durch kaschieren, extrudieren etc. aufgebracht wird, vor mechanischen Einflüssen geschützt.

Als folienförmige Werkstoffe sind z.B. Folien, Laminate, Verbunde oder Schichtstoffe zu nennen. Die folienförmigen Werkstoffe können thermoplastische Kunststoffe, beispielsweise Thermoplaste auf Olefm-Basis, auf Ester-Basis, auf Polyamid-Basis oder halogenhaltige Kunststoffe, ferner Poly-Acetate, -Acrylate, -Arylensulfide, -Arylensulfone, -Arylencarbonate, -Carbonate, -Imide, -Styrole oder Gemische davon, enthalten oder daraus bestehen. Insbesondere können die zu beschichtenden Oberflächen der folienförmigen Werkstoffe die genannten Kunststoffe enthalten oder daraus bestehen.

Die folienförmigen Werkstoffe können auch aus oder mit cellulosehaltigen Werkstoffe wie Papier, Pappe, Karton, papierhaltigen Formmassen etc., hergestellt sein oder mit Hilfe solcher Werkstoffe verstärkt sein.

Die Dicke einer einzelnen Kunststoffolie als Monofilm oder der einzelnen Kunststoffolien in Folienverbunden oder Laminaten kann beispielsweise bei 4 bis 2000 µm, bevorzugt bei 6 bis 600 µm und insbesondere bei 6 bis 150 µm liegen.

Folienverbunde oder Laminate können die an sich bekannten Schichtaufbauten aufweisen, wie z.B. enthaltend wenigstens zwei Kunststoffschichten, oder enthaltend wenigstens eine cellulosehaltige Schicht und wenigstens eine Kunststoffschicht.

Die folienförmigen Werkstoffe können auch auf wenigstens einer Aussenseite eine an Siegelschicht aus z.B. Polyethylenen oder Polypropylenen enthalten.

Alle Substrate können glasklar, getrübt, durchgefärbt, farbbedeckt oder bedruckt angewendet werden.

Die Verbunde und Laminate, wie in vorliegender Beschreibung erwähnt, können auf an sich bekannte Weise, z.B. durch Beschichten, Extrusionsbeschichten, Coextrusionsbeschichten, Kaschieren, Gegenkaschieren oder Heisskalandrieren hergestellt werden.

Die verschiedenen Schichten und insbesondere die Kunststoffolien oder -schichten untereini ander, können mit Kaschierklebern und/oder Haftvermittlern und gegebenenfalls Vorlack miteinander zu den Laminaten oder Verbunden verarbeitet werden.

Die durch Verdampfen der anorganischen Materialien aus der Reihe von Metallen, Halbmetallen, Metall- und/oder Halbmetallverbindungen auf das Substrat aufgebrachte Überzugsschicht aus anorganischen Stoffen, kann beispielsweise eine Dicke von 5 bis 500 nm (Nanometer), zweckmässig von 10 bis 200 nm und bevorzugt von 40 bis 150 nm aufweisen.

Im Verdampfertiegel oder auf einem Verdampfertiegel sind die anorganischen Materialien als Ausgangsmaterialien für die Überzugsschicht angeordnet. Geeignete anorganische Materialien können auch gleichzeitig den Verdampfertiegel bilden

Als anorganische Materialien kann ein einzelner anorganischer Stoff oder es können zwei, drei oder mehrere anorganische Stoffe nebeneinander oder im Gemisch angewendet werden.

In weiterer zweckmässiger Ausführungsform des Verfahrens werden wenigstens zwei anorganische Materialien gleichzeitig unter Ausbildung eines Dampfgemisches im Vakuum verdampft und das Dampfgemisch der anorganischen Stoffe auf den thermoplastischen Kunststoff des Substrates niedergeschlagen wird.

Als anorganische Materialien können zwei verschiedene Metalle, Halbmetalle, Metall- und/oder Halbmetallverbindungen gleichzeitig, unter Ausbildung eines Dampfgemisches, im Vakuum verdampft werden oder es können ein Metall oder ein Halbmetall oder ein Metallgemisch oder ein Halbmetallgemisch oder ein Metall/Halbmetallgemisch und eine oder mehrere Metall- und /oder Halbmetallverbindungen verdampft werden.

Bevorzugt sind als anorganische Stoffe die Metalle und Halbmetalle Silicium, Aluminium, Chrom, Magnesium, Lanthan, Titan, Bor und Zirkon und als Metall- und Halbmetallverbindungen die Oxide, Carbide und Nitride des Siliciums, des Aluminiums, des Magnesiums, des Chroms, des Lanthans, des Titans, des Bors und des Zirkons. Die anorganischen Stoffe können als Gemisch in einem oder mehreren Verdampfertiegeln oder jeder Stoff für sich in einem oder mehreren Verdampfertiegeln vorliegen.

Möglich sind auch Verfahren, bei denen als anorganische Materialien wenigstens zwei Metall- und/oder Halbmetallverbindungen angewendet werden, wobei eine Verbindung ein Oxid des Siliciums und wenigstens die weitere Verbindung ein Oxid des Aluminiums, des Magnesiums, des Lanthans, des Titans, des Bors oder des Zirkons darstellt.

Bevorzugt sind anorganische Materialien aus einer Mischung aus einem oder mehreren Oxiden des Siliciums, Aluminiums, Magnesiums, oder Bors und einem oder mehreren Halbmetallen und/oder Metallen, wie z.B. Bor, Silicium, Aluminium, Zink, Zinn und Chrom.

Oxide des Siliciums können von der Formel $SiO_x$, Wobei x eine Zahl von 1 bis 2 darstellt, umfasst sein. Oxide des Aluminiums können von der Formel $Al_yO_z$, wobei der Faktor y/z eine Zahl von 0,2 bis 1,5 darstellt, umfasst sein.

Besonders bevorzugt als anorganische Materialien werden $SiO_2$ und $Al_2O_3$ oder $SiO_2$ und MgO oder $SiO_2$ und $La_2O_3$ oder $SiO_2$ und $La_2O_3$ oder $SiO_2$ und $TiO_2$ oder $SiO_2$ und $ZrO_2$ oder $SiO_2$ und $B_2O_3$ gleichzeitig aufgedampft.

In weiterer bevorzugter Ausgestaltung des Verfahrens kann während der Verdampfung der anorganischen Materialien das Substrat mit $N_2$-, Ar- oder $O_2$-Ionen beschossen.

Ebenfalls kann das Verdampfen und Niederschlagen in reaktiver Atmosphäre erfolgen.

Die anorganischen Materialien im Verdampfertiegel können als Füll-, Klopf-, Press-, Schütt-, Stopf-, Schaum- zweckmässig Sintermassen vorliegen.

Die anorganischen Materialien in Verdampfertiegel können z.B. in einer Rohdichte vorliegen, die 25 bis 75 % der Reindichte der jeweiligen anorganischen Materialien beträgt.

Bevorzugt beträgt die Rohdichte 40 bis 60 % und insbesondere 50 % der Reindichte der anorganischen Materialien.

Solche Rohdichten sind beispielsweise die Schütt- oder Fülldichten durch lose eingefülltes oder in bestimmter Weise geschüttetes Pulver, Körner oder Fasern zu Haufwerken in den Tiegel. Wird diese Fülldichte durch loses Einfüllen nicht erreicht, können das Pulver, die Körner oder Fasern durch Klopfen dichter gelagert werden, so dass die gewünschte Klopfdichte erreicht wird. Es kann auch durch Anlegen von Pressdruck an das Haufwerk von Pulver, Körnern oder Fasern die geforderte Pressdichte erzielt werden. Beispielsweise können Pressdrücke von 1 bis 100 kg/cm$^2$ und zweckmässig von 40 bis 60 kg/cm$^2$ angelegt werden.

Beispielsweise kann ein solches Füllgut für den Verdampfertiegel dadurch erzeugt werden, dass die entsprechenden anorganischen Materialien beispielsweise durch Fällung, Kristallisation, Mahlen, Agglomerieren oder Sieben auf eine Korngrösse von 0,05 bis 1000 μm gebracht werden. Anschliessend können die anorganischen Materialien kalt und trocken vermischt und als Haufwerk oder, mit oder ohne Binder, wie z.B. Polyvinylalkohol oder Polyvinylacetat, vermischt und verpresst, als Presskörper in einen Verdampfertiegel gegeben werden.

Die Verbindungen können auch durch Lösen oder Gelieren in starken Mineralsäuren, mischen und fällen, z.B. nach dem Sol-Gel-Verfahren, trocknen und in den Verdampfertiegel formen, hergestellt werden.

Andere Verfahren zur Herstellung des Füllgutes aus den Metallen, Halbmetallen, Metall- und/oder Halbmetallverbindungen für den Verdampfertiegel sind z.B. isostatisches uniaxiales Pressen, Extrudieren oder Schlickergiessen des entsprechenden Pulvergemisches. Auch kann man die entsprechenden Formen giessen oder verdüsen oder versprühen.

Um die gewünschten Rohdichten zu erreichen, insbesondere wenn es sich um Sinterdichten handelt, kann das Füllgut auch mit z.B. organischen Bestandteilen gemischt werden, die während dem Trocknen und/oder Sintern durch Verdampfen oder Verbrennen sich verflüchtigen und Hohlräume hinterlassen. Oder es können Haufwerke oder Presskörper auf die gewünschte Dichte gesintert werden.

Schaummassen sind z.B. erhältlich durch imprägnieren eines organischen Schaumes mit dem Füllgut, wobei das Füllgut in Schlickerform gebracht wird, trocknen des Schlickers auf dem organischen Schaum und ausbrennen des organischen Schaumes, wobei das Füllgut in Form eines Abbildes des organischen Schaumes zurückbleibt.

Es ist auch möglich, Schaummassen durch Treibmittel, welche dem Füllgut zugegeben werden, zu erzeugen.

Zum Verdampfen des Tiegelinhaltes wird der Inhalt direkt über einen Elektronenstrahl oder Laserstrahl beheizt. Je nach verwendetem Gemisch verdampft der Tiegelinhalt bei Temperaturen von 1100 bis 2000°C. Die dabei entstehende Gasphase hat in den meisten Fällen eine wesentlich andere Zusammensetzung als der Inhalt im Tiegel selbst. Dadurch ergeben sich auch stark veränderte Zusammensetzungen der aus der Gasphase auf dem Substrat abgeschiedenen Schichten aus anorganischen Stoffen.

Um die geforderte Leistungsdichte für den Verdampfungsprozess des anorganischen Materials zu erreichen, können als Energiequellen auch insbesondere Festkörper- oder Moleküllaser verwendet werden. Besonders geeignet sind Festkörperlaser, wie die Neodym: YAG-Laser oder Moleküllaser, wie beispielsweise

der $CO_2$-Laser.

Der für die Materialbearbeitung wichtigste Moleküllaser ist der $CO_2$-Laser, der über 100 Wellenlängen im Bereich 9,14 µm bis 11,01 µm mit einer Maximalintensität bei 10,6 µm aufweist. Er zeichnet sich durch einen hohen Wirkungsgrad und eine hohe Ausgangsleistung im kontinuierlichen Betrieb ab. Für das Verdampfen des anorganischen Materials eignet sich zweckmässigerweise ein $CO_2$-Laser einer Leistungsstärke zwischen 2 und 15 kW.

Der für technische Anwendungen wichtigste Festkörperlaser ist der Nd (Neodym): YAG-Laser. YAG ist die Abkürzung für Yttrium-Aluminium-Granat ($Y_3Al_5O_{12}$). Der leistungsstärkste Laserübergang eines Nd: YAG-Lasers liegt bei der Wellenlänge $\lambda$ = 1,064 µm. Für das Verdampfen des anorganischen Materials eignen sich zweckmässigerweise Nd: YAG-Laser mit einer Leistungsstärke zwischen 0,5 und 3 kW und insbesondere von 1 bis 1,4 kW.

Die Abscheidung der Schichten aus der Gasphase erfolgt auf einem Substrat, das entweder auf Erdpotential liegt oder eine negative oder positive Potentialdifferenz gegenüber der Umgebung besitzt. Die Abscheidung findet im Vakuum statt, wobei in der Regel der verminderte Druck kleiner als $10^{-3}$ mbar ist. Die Reaktivgasatmosphäre kann durch Stickstoff, Sauerstoff, Wasserdampf, Kohlenwasserstoffe, wie Acetylen, usw. gebildet werden.

Durch die Reaktivgasatmosphäre können die verdampften anorganischen Stoffe, beispielsweise Metalle in ihre Oxide (mit Sauerstoff) oder in ihre Carbide (z.B. mit Acetylen) umgesetzt werden, resp. Oxide können z.B. zu Carbiden umgesetzt werden. Entsprechend der Reaktivgasatmosphäre und den Verdampfungs- und Abscheidungsraten kann sich die Zusammensetzung der anorganischen Materialien auf dem Substrat von demjenigen in der Gasatmosphäre und im Verdampfertiegel unterscheiden

Vor und/oder während und/oder nach der Abscheidung kann das Substrat mit Ionen aus einer Ionenquelle beschossen werden. Bevorzugt wird das Substrat während der Verdampfung mit $N_2$-, Ar- oder $O_2$-Ionen beschossen.

Vorliegende Erfindung betrifft vorzugsweise eine Elektronen- oder Laserstrahlkanone, deren Strahl in einem Winkel $\alpha$ von 20 bis 70°, vorzugsweise 30 bis 60°, auf die Oberfläche des anorganischen Materials gerichtet ist.

Der Verdampfertiegel und die Elektronen- oder Laserstrahlkanone sind vorteilhaft bezüglich ihrer Längsachsen zueinander beweglich.

In der erfindungsgemässen Vorrichtung ist die Bewegungsrichtung derart, dass der Verdampfertiegel auf den im Winkel $\alpha$ auf die Oberfläche der anorganischen Materialien treffen Elektronen- oder Laserstrahl zuläuft. Die Oberfläche der anorganischen Materialien im Verdampfertiegel bildet vorzugsweise eine horizontale Ebene.

Die erfindungsgemässe Vorrichtung kann in der Vakuumkammer bevorzugt eines oder aber i auch mehrere Substrate enthalten, beispielsweise in Form von Abschnitten oder Endlosware in Rollenform, wobei die Endlosware fortlaufend abgerollt, beschichtet und auf einer zweiten Rolle wieder aufgerollt wird. Es ist auch möglich zwei oder mehrere Verdampfertiegel in der Vakuumkammer vorzusehen, wobei die Tiegel die gleichen oder unterschiedliche anorganische Materialien enthalten können. Die Vakuumkammer kann zweckmässig mit einer, fallweise auch mehreren, Elektronenstrahl- oder Laserkanone ausgerüstet sein.

Vorliegende Erfindung betrifft auch ein Verfahren zum Beschichten einer Substratfläche mit einer Überzugsschicht aus anorganischen Materialien durch Verdampfen von anorganischen Materialien aus einem Verdampfertiegel in Vakuum, wobei der Verdampfertiegel und das Substrat in einer Vakuumkammer angeordnet sind und eine im Bereich der Vakuumkammer angeordnete Elektronenstrahl- oder Laserkanone einen Elektronen- oder Laserstrahl auf die im Verdampfertiegel befindlichen anorganischen Materialien ausstrahlt, wobei die anorganischen Materialien aus dem Verdampfertiegel abdampfen und sich auf der Substratfläche niederschlagen.

Nach dem Verfahren vorliegender Erfindung trifft der ausgestrahlte Elektronen- oder Laserstrahl in einem Winkel $\alpha$ auf die Oberfläche der anorganischen Materialien auf, wobei der Elektronen- oder Laserstrahl und die Oberfläche der anorganischen Materialien einen Winkel $\alpha$ von 10 bis 80° einschliessen und während des Verdampfens der anorganischen Materialien der Verdampfertiegel und die Elektronen- oder Laserkanone bezüglich ihrer Längsachsen relativ zueinander bewegt werden und beim Abdampfen des anorganischen Materials bildet sich ein Überhang im anorganischen Material aus und es besteht geometrisch keine Sichtverbindung zwischen dem Auftreffpunkt des Elektronen- oder Laserstrahls auf den anorganischen Materialien und dem Substrat.

Bevorzugt ist ein Winkel $\alpha$ von 20 bis 70° und besonders bevorzugt von 30 bis 60°.

Bevorzugt ist ein Verfahren nach vorliegender Erfindung, bei dem während des Verdampfens der anorganischen Materialien der Elektronen- oder Laserstrahl gegenüber dem Verdampfertiegel oszillierend seitwärts bewegt und der Verdampfertiegel und der Elektronen- oder Laserstrahl mit einer Geschwindigkeit $V_T$ relativ zueinander bewegt werden und die Geschwindigkeit $V_T$ in Abhängigkeit von der Grösse des Winkels $\alpha$ erfolgt, wobei die Geschwindigkeit $V_T$ mit der allgemeinen Formel:

$$V_T = \frac{M}{t \times b} \times \frac{1}{\tan(\alpha) \times \Lambda \times \rho}$$

ausgedrückt wird, wobei A der Überhang in cm, $\rho$ die Dichte des anorganischen Materials, M die Masse des abgedampften Materials, t die Zeiteinheit und b die Schwenkbreite des Elektronen- oder Laserstrahls in cm ist. In der Praxis kann der Überhang $\Lambda$ 0,5 bis 10 cm, zweckmässig 1 bis 5 cm betragen, wobei der Überhang so gross ist, dass keine direkte oder geometrische Sichtverbindung zwischen dem Auftreffpunkt des Elektronen- oder Laserstrahls und dem Substrat besteht. Die Rohdichte, d.h. die Materialdichte oder die Schüttdichte $\rho$ kann 0,6 bis 3,0 g/cm$^3$, zweckmässig 0,8 bis 1,6 g/cm$^3$ und bevorzugt 0,9 bis 1,2 g/cm$^3$ sein. Die Schwenkbreite oder Scannerbreite des Elektronen- oder Laserstrahls kann beispielsweise 10 bis 300 cm betragen.

Bei der Ausführung des vorliegenden Verfahrens werden der Verdampfertiegel und der Elektronen- oder Laserstrahl während des Verdampfens der anorganischen Materialien relativ zueinander bewegt. Dies kann dadurch erfolgen, dass der Verdampfertiegel in seiner Längsachse unter einem feststehenden Elektronen- oder Laserstrahl hindurch bewegt wird oder dass der Elektronen- oder Laserstrahl, in der Längsachse des Verdampfertiegels, längs über diesen hinweg, bewegt wird oder dass der Elektronen- oder Laserstrahl um eine Drehachse bewegt wird oder es kann eine Kombination zweier oder aller Varianten erfolgen. Die erste Variante des alleinigen Bewegens des Verdampfertiegels wird bevorzugt. Besonders bevorzugt wird der Verdampfertiegel in Richtung, gegen den in spitzem Winkel $\alpha$ auftreffenden Elektronen- oder Laserstrahl hin, bewegt. Da in der Regel während dem Verfahren der Elektronen- oder Laserstrahl oszillierend seitwärts ausschwenkt und der Verdampfertiegel sich relativ zum Elektronen- oder Laserstrahl bewegt, wird die ganze Verdampfertiegeloberfläche und damit die ganze Oberfläche des anorganischen Materials abgescannt, d.h. vom Elektronen- oder Laserstrahl bestrichen und dabei das anorganische Material durch Verdampfen abgetragen. Das Bewegen des Verdampfertiegels kann durch z.B. mechanische, hydraulische, pneumatische, magnetische oder elektromagnetische Mittel erfolgen.

Der Überhang an organischen Materialien stellt insbesondere den während des kontinuierlichen, stabilen Ablaufes des Prozesses eingestellten Zustand dar. Beim Anfahren des Prozesses kann der Elektronen- oder Laserstrahl auf eine noch ebene Oberfläche des anorganischen Materials treffen und mit dem beginnenden Abdampfen des anorganischen Materials bildet sich rasch der erforderliche Überhang aus.

Die Erfindung wird anhand von in der Zeichnung dargestellten Ausführungsbeispielen näher erläutert. Es zeigen:

- Fig. 1 eine Prinzipskizze einer Beschichtungsvorrichtung

- Fig. 2 eine Detailskizze aus Figur 1 mit dem Verdampfertiegel.

- Fig. 3 eine Draufsicht auf den Verdampfertiegel

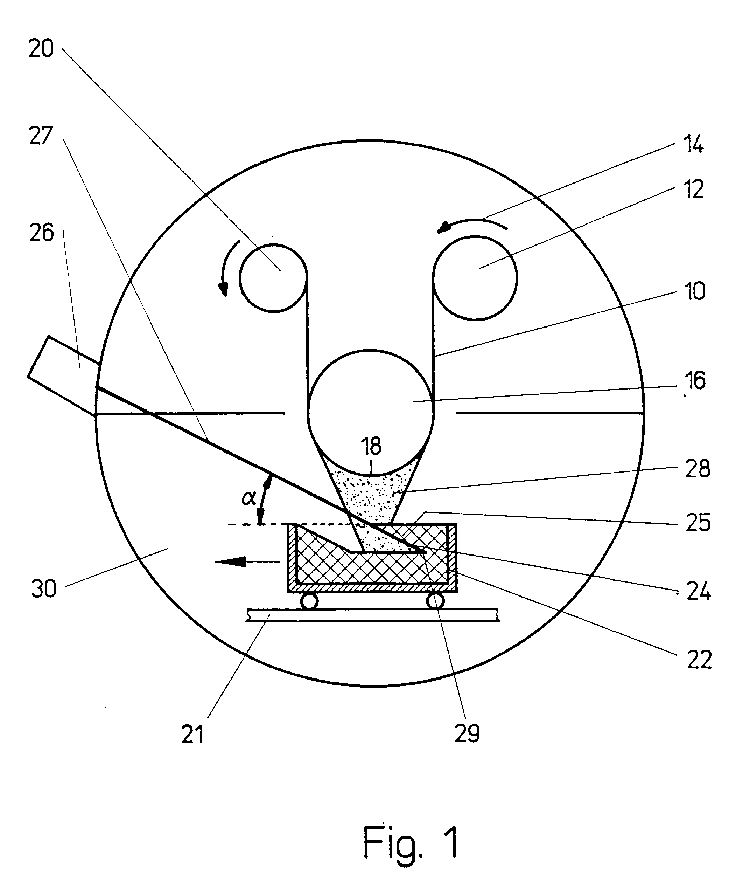

Nach der Ausführungsform von Fig. 1 wird in einer Vakuumkammer 30 (die Absaugvorrichtungen sind nicht gezeigt) als Substrat eine Kunststoffolie 10 von einer Rolle 12 in Richtung des Pfeils 14 abgewickelt und über eine Walze 16 gezogen. Die auf der Walze 16 als Substratträger aufliegende Kunststoffolie 10 bildet im Arbeitsbereich die Substratfläche 18. Nach der Beschichtung wird die Kunststoffolie 10 auf eine weitere Rolle 20 aufgewickelt. Allfällige Umlenkrollen sind einfachheitshalber nicht gezeichnet.

In einem Verdampfertiegel 22 befindet sich das zu verdampfende anorganische Material 24, welches von einer scannenden Hochspannungs-Elektronenstrahlkanone 26 im Bereich einer Auftreffzone 29 erhitzt wird. Durch die Energie des Elektronenstrahls 27 bildet sich eine Gasphase 28 aus anorganischem Material 24. Durch das Verdampfendes anorganischen Materials 24 und die Bewegung des Tiegels 22 gegenüber dem Elektronenstrahl 27, bildet sich ein sich stetig fortsetzender Überhang 25 aus.

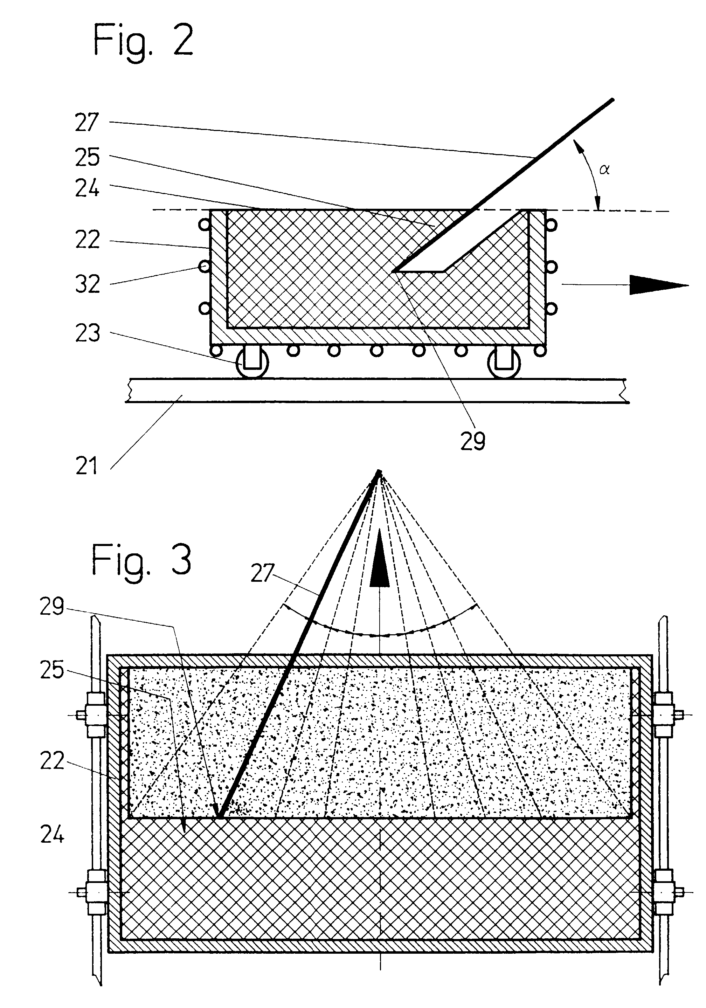

Die Figur 2 zeigt eine Detailskizze aus der Vorrichtung gemäss Figur 1.

Der Tiegel 22 aus Boden und Seitenwänden ist hier beispielhaft mit einer Kühlvorrichtung in Form von Kühlschlangen versehen. In den Kühlschlangen kann beispielsweise eine Flüssigkeit wie Wasser oder Kühlsole zirkulieren. In vielen Fällen ist eine Strahlungskühlung ausreichend, insbesondere bei schlechter Wärmeleitfähigkeit des anorganischen Materials, da sich in diesem Falle das anorganische Material nur eng begrenzt im Auftreffbereich des Elektronenstrahls erhitzt. Der Tiegel 22 ist auf Rollen 23 gelagert und kann durch einen Antrieb bewegt werden. Die Rollen 23 stehen auf einer Unterlage 21, die innerhalb der Vakuumkammer 30 angeordnet ist. Anstelle von Rollen können auch Gleitnägel, Gleitsteine, Kufen, Walzen, Kugelrollen, Räder usw. vorgesehen werden.

Der Tiegel 22 ist mit dem anorganischen Material 24 befüllt. Entsprechend der Anwendungsform des anorganischen Materials 24, d.h. z.B. als Schüttung oder aber als Festkörper kann die Ausgestaltung des Tiegels 22 beispielsweise als Plattform, als Trog oder Wanne oder als Schale erfolgen. Der Elektronenstrahl 27 oder Laserstrahl 27 trifft auf die Oberfläche des anorganischen Materials 24 unter einem Winkel $\alpha$ auf. Der Winkel $\alpha$ beträgt 10 bis 80°. Demnach tritt der Elektronen- oder fallweise Laserstrahl in einem spitzen Winkel $\alpha$ auf die Oberfläche des anorganischen Materials 24. Die Oberfläche des anorganischen Materials stellt im wesentlichen eine ebene Fläche dar. Der verschiebbare Tiegel 22 kann vom Elektronenstrahl 27 weg, d.h. vorwärts, oder auf den Elektronenstrahl zu, d.h. rückwärts, bewegt werden, wobei die Rückwärtsbewegung, wie mit dem Pfeil angedeutet, bevorzugt wird.

Auch in Figur 1 ist die bevorzugte Bewegungsrichtung des Tiegels 22 durch einen Pfeil angedeutet.

Anstelle der Bewegung des Tiegels kann auch der Elektronen- oder Laserstrahl vorwärts- und rückwärts durch Verschieben der Elektronenstrahl- oder Laserkanone oder durch Verschwenken der Elektronen- oder Laserstrahlkanone bewegt werden. Die Bewegungsarten können auch kombiniert werden. Eine Bewegungsrichtung des Strahls gegen den Tiegel, wobei das anorganische Material im Tiegel gegen den spitzen Winkel $\alpha$ läuft, wird bevorzugt. Der Tiegel 22 kann auf einer horizontalen Ebene verschoben werden, es ist jedoch auch möglich, den Tiegel auf einer Schräge oder entlang einer Biegung zu bewegen.

Die beschriebene Anordnung und Bewegungsrichtung führt nun zur Ausbildung eines Überhanges 25, gebildet aus dem anorganischen Material. Dieser Überhang 25 wird einerseits durch das im wesentlichen kontinuierlichen Bewegen des Tiegels entgegen der Strahlrichtung an seiner Unterseite abgebaut und bildet sich im unteren Bereich neu aus, so dass ein Gleichgewicht entsteht. Der Überhang 25 verhindert, dass eine direkte oder geometrische Sichtverbindung zwischen der Verdampfungszone und dem Substrat besteht. Diese Tatsache und die gleichmässige Materialzuführung in die Verdampfungszone auf Grund dieser Anordnung führen nun überraschenderweise zu einer besonders homogenen Bedampfung und zu Schichten mit stark reduzierter Defektdichte. Dies wiederum erlaubt eine höhere Verdampfungsleistung als mit herkömmlichen Verfahren.

Die Figur 3 zeigt eine Draufsicht auf einem Tiegel 22. Der Tiegel 22 ist beispielhaft als rechteckförmige Wanne ausgestaltet. In anderer Ausführungsform könnte der Tiegel eine Platte darstellen, auf der das anorganische Material angeordnet ist. Der Tiegel 22 kann in einer Achsrichtung verschoben werden, wobei die bevorzugte Verschieberichtung mit einem Pfeil angedeutet ist. Der Elektronen- oder Laserstrahl 27 aus der Elektronenstrahlkanone oder einem Hochleistungs-Laser (nicht gezeigt) wird oszillierend abgelenkt und in einer linienformigen Auftreffzone 29 des Strahles 27 wird das anorganische Material 24 geschmolzen und verdampft oder sublimiert. Die Ablenkung erfolgt oszillierend mit einer Frequenz von beispielsweise wenigstens 5 Hz und vorzugsweise wenigstens 30 Hz. Diese linienförmige Auftreffzone 29 des Strahles 27 liegt im wesentlichen senkrecht zur Verfahrrichtung des Tiegels mit dem anorganischen Material 24. Es bildet sich der Überhang 25 im anorganischen Material 24 aus. Da der Tiegel unter stetigem Vorschub steht, wird das anorganische Material nach und nach über die volle Länge und Breite des Tiegels abgetragen.

Die mit vorliegender Vorrichtung und nach dem vorliegenden Verfahren beschichteten Substrate eignen sich beispielsweise für die Verwendung als Verpackungsmaterialien oder Packstoffe oder zur Herstellung von Verpackungsmaterialien oder Packstoffen, wie Verpackungsfolien resp.-laminate. Es können beispielsweise Verpackungsmaterialien und Packstoffe erzeugt werden, deren anorganische Beschichtung oder Überzüge frei oder arm an Fehlstellen sind und keine Inhomogenitäten, wie Partikeleinschlüsse, Ablagerungen und Spritzer, aus anorganischem Material aufweisen. Aus diesen Verpackungsmaterialien können beispielsweise Verpackungsbehälter, wie Beutel, Sachets, Einwickler, Taschen, schalenförmige Behälter, Tiefziehpackungen, Menuschalen und dgl. hergestellt werden oder es können Deckelmaterialien für Tiefziehpackungen oder schalenförmige Behälter gefertigt werden. Derartige Behältnisse eignen sich beispielsweise zur Aufnahme von Nahrungsmitteln für Mensch oder Tier oder für Genussmitteln, jeweils in fester bis flüssiger Form. Weitere Anwendungsgebiete für das Verpackungsmaterial sind Verpackungen für die Pharmazie und Medizin, wie Tablettenverpackungen und Durchdrückpackungen.

**Patentansprüche**

1. Vorrichtung enthaltend eine Vakuumkammer 30 und darin angeordnet ein Substrat 10 und ein mit anorganischen Materialien 24 befüllter Verdampfertiegel 22 und eine im Bereich der Vakuumkammer 30 angebrachte Elektronenstrahl- oder Laserkanone 26, deren Elektronen- oder Laserstrahl 27 auf die Oberfläche der anorganischen Materialien 24 im Verdampfertiegel 22 gerichtet ist, zum Beschichten einer Substratfläche 18 mit einer Überzugsschicht aus anorganischen Materialien durch Verdampfen der anorganischen Materialien 24, dadurch gekennzeichnet, dass
der Elektronen- oder Laserstrahl 27 und die Oberfläche der anorganischen Materialien 24 einen Winkel $\alpha$ von 10 bis 80° einschliessen und der Verdampfertiegel und die Elektronen- oder Laserstrahlkanone bezüglich ihrer Längsachsen relativ zueinander beweglich sind, wobei sich beim Abdampfen der anorganischen Materialien 24 ein Überhang 25 an anorganischen Materialien 24 ausbildet und geometrisch keine Sichtverbindung von den verdampfenden anorganischen Materialien zur Substratfläche 18 besteht.

2. Vorrichtung nach Anspruch 1, dadurch gekennzeichnet, dass der Winkel $\alpha$ 20° bis 70°, vorzugsweise 30° bis 60°, beträgt.

3. Vorrichtung nach Anspruch 1, dadurch gekennzeichnet, dass der Verdampfertiegel, auf den im Winkel $\alpha$ auf die Oberfläche der anorganischen Materialien treffenden Elektronen- oder Laserstrahl zulaufend, beweglich ist.

4. Vorrichtung nach Anspruch 1, dadurch gekennzeichnet, dass der Elektronen- oder Laserstrahl gegenüber der Längsachse des Verdampfertiegels seitwärts oszillierend beweglich ist.

5. Vorrichtung nach Anspruch 1, dadurch gekennzeichnet, dass die Oberfläche der anorganischen Materialien im Verdampfertiegel eine horizontale Ebene bildet.

6. Verfahren zum Beschichten einer Substratfläche 18 mit einer Überzugsschicht aus anorganischen Materialien durch Verdampfen von anorganischen Materialien 24 aus einem Verdampfertiegel 22 in Vakuum, wobei der Verdampfertiegel 22 und das Substrat 10 in einer Vakuumkammer 30 angeordnet sind und eine im Bereich der Vakuumkammer angeordnete Elektronenstrahl- oder Laserkanone 26 einen Elektronen- oder Laserstrahl 27 auf die im Verdampfertiegel 22 befindlichen anorganischen Materialien 24 ausstrahlt, wobei die anorganischen Materialien 24 aus dem Verdampfertiegel 22 abdampfen und sich auf dem Substrat 10 niederschlagen,
dadurch gekennzeichnet, dass
der ausgestrahlte Elektronen- oder Laserstrahl 27 in einem Winkel α auf die Oberfläche des anorganischen Materialien 24 auftrifft, wobei der Elektronen- oder Laserstrahl 27 und die Oberfläche der anorganischen Materialien 24 einen Winkel α von 10 bis 80° einschliessen und während des Verdampfens der anorganischen Materialien der Verdampfertiegel und die Elektronen- oder Laserstrahlkanone bezüglich ihrer Längsachsen relativ zueinander bewegt werden und sich beim Abdampfen des anorganischen Materials 24 ein Überhang 25 im anorganischen Material 24 ausbildet und geometrisch keine Sichtverbindung zwischen dem Auftreffpunkt 29 des Elektronen- oder Laserstrahls 27 auf den anorganischen Materialien und der Substratfläche 18 besteht.

7. Verfahren nach Anspruch 6, dadurch gekennzeichnet, dass der Winkel α 20° bis 70° und vorzugsweise 30° bis 60° beträgt.

8. Verfahren nach Anspruch 6, dadurch gekennzeichnet, dass während des Verdampfens der anorganischen Materialien der Verdampfertiegel, auf den im Winkel α auf die Oberfläche des anorganischen Materials auftreffenden Elektronen- oder Laserstrahl zulaufend, bewegt wird.

9. Verfahren nach Anspruch 6, dadurch gekennzeichnet, dass während des Verdampfens der anorganischen Materialien der Elektronen- oder Laserstrahl, gegenüber der Längsachse des Verdampfertiegels, oszillierend seitwärts bewegt wird.

10. Verfahren nach Anspruch 6, dadurch gekennzeichnet, dass während des Verdampfens der anorganischen Materialien der Elektronen- oder Laserstrahl gegenüber dem VerVerdampfertiegels, oszillierend seitwärts bewegt und der Verdampfertiegel und der Elektronen- oder Laserstrahl mit einer Geschwindigkeit $V_T$ relativ zueinander bewegt werden und die Geschwindigkeit $V_T$ in Abhängigkeit von der Grösse des Winkels α erfolgt, wobei die Geschwindigkeit $V_T$ der allgemeinen Formel folgt:

$$V_T = \frac{M}{t \times b} \times \frac{1}{\tan(\alpha) \times \Lambda \times \rho}$$

wobei Λ der Überhang in cm, ρ die Rohdichte des anorganischen Materials, M die Masse des abgedampften Materials, t die Zeiteinheit und b die Schwenkbreite des oszillierenden Elektronen- oder Laserstrahls in cm ist.

11. Verfahren nach Anspruch 7, dadurch gekennzeichnet, dass die Oberfläche des anorganischen Materials eine horizontale Ebene bildet und die anorganischen Materialien durch Verdampfen abgetragen werden.

**Claims**

1. Device containing a vacuum chamber 30 and arranged therein a substrate 10 and an evaporator crucible 22 filled with inorganic materials 24 and an electron-beam gun or laser gun which is mounted in the region of the vacuum chamber 30 and the electron beam or laser beam 27 of which is directed on to the surface of the inorganic materials 24 in the evaporator crucible 22 in order to coat a substrate surface 18 with a coating of inorganic materials by evaporating the inorganic materials 24, characterised in that the electron beam or laser beam 27 and the surface of the inorganic materials 24 include an angle α of 10 to 80° and the evaporator crucible and the electron-beam gun or laser-beam gun are movable relative to one another with respect to their longitudinal axes, an overhang 25 of inorganic materials 24 being formed when the inorganic materials 24 are evaporated and there being no visible geometric connection between the evaporating inorganic materials and the substrate surface 18.

2. Device according to claim 1, characterised in that the angle α is 20° to 70°, preferably 30° to 60°.

3. Device according to claim 1, characterised in that the evaporator crucible is movable towards the electron beam or laser beam striking the surface of the inorganic materials at an angle α.

4. Device according to claim 1, characterised in that the electron beam or laser beam is movable sideways in an oscillating manner with respect to the longitudinal axis of the evaporator crucible.

**5.** Device according to claim 1, characterised in that the surface of the inorganic materials in the evaporator crucible forms a horizontal plane.

**6.** Process for coating a substrate surface 18 with a coating of inorganic materials by evaporating inorganic materials 24 out of an evaporator crucible 22 in vacuo, the evaporator crucible 22 and the substrate 10 being arranged in a vacuum chamber 30 and an electron-beam gun or laser gun 26 arranged in the region of the vacuum chamber emitting an electron beam or laser beam 27 on to the inorganic materials 24 situated in the evaporator crucible 22, the inorganic materials 24 being evaporated out of the evaporator crucible 22 and deposited on the substrate 10, characterised in that the electron beam or laser beam 27 emitted strikes the surface of the inorganic materials 24 at an angle $\alpha$, the electron beam or laser beam 27 and the surface of the inorganic materials 24 including an angle $\alpha$ of 10 to 80° and the evaporator crucible and the electron-beam gun or laser-beam gun being moved relative to one another with respect to their longitudinal axes during the evaporation of the inorganic materials and an overhang 25 being formed in the inorganic material 24 when the inorganic material 24 is evaporated and there being no visible geometric connection between the point of incidence 29 of the electron beam or laser beam 27 on the inorganic materials and the substrate surface 18.

**7.** Process according to claim 6, characterised in that the angle $\alpha$ is 20° to 70° and preferably 30° to 60°.

**8.** Process according to claim 6, characterised in that the evaporator crucible is moved towards the electron beam or laser beam striking the surface of the inorganic material at an angle $\alpha$ during the evaporation of the inorganic materials.

**9.** Process according to claim 6, characterised in that the electron beam or laser beam is moved sideways in an oscillating manner with respect to the longitudinal axis of the evaporator crucible during the evaporation of the inorganic materials.

**10.** Process according to claim 6, characterised in that the electron beam or laser beam is moved sideways in an oscillating manner with respect to the evaporator crucible during the evaporation of the inorganic materials and the evaporator crucible and the electron beam or laser beam are moved relative to one another at a speed $V_T$ and the speed $V_T$ is a function of the magnitude of the angle $\alpha$, the speed $V_T$ being expressed by the general formula:

$$V_T = \frac{M}{t \times b} \times \frac{1}{\tan(\alpha) \times \Lambda \times \rho}$$

where $\Lambda$ is the overhang in cm, $\rho$ is the bulk density of the inorganic material, M is the mass of the evaporated material, t is the unit of time and b is the swivel range of the oscillating electron beam or laser beam in cm.

**11.** Process according to claim 7, characterised in that the surface of the inorganic material forms a horizontal plane and the inorganic materials are removed by evaporation.

**Revendications**

**1.** Dispositif contenant une chambre à vide (30) et un substrat (10) qui y est disposé et un creuset de vaporisation (22) rempli de matériaux inorganiques (24) et un canon à faisceau d'électrons ou un canon laser (26) disposé à proximité de la chambre à vide (30), dont le faisceau d'électrons ou le faisceau laser (27) est dirigé sur la surface des matériaux inorganiques (24) dans le creuset de vaporisation (22), afin de revêtir une surface de substrat (18) avec une couche de revêtement de matériaux inorganiques par vaporisation des matériaux inorganiques (24), caractérisé en ce que le faisceau d'électrons ou le faisceau laser (27) et la surface des matériaux inorganiques (24) forment un angle $\alpha$ de 10° à 80° et le creuset de vaporisation et le canon à faisceau d'électrons ou le canon laser sont mobiles relativement l'un par rapport à l'autre vis-à-vis de leurs axes longitudinaux, un surplomb (25) des matériaux inorganiques (24) se formant lors de la vaporisation des matériaux inorganiques (24) et aucun contact visuel n'existant géométriquement vers la surface de substrat (18) depuis les matériaux inorganiques.

**2.** Dispositif suivant la revendication 1, caractérisé en ce que l'angle $\alpha$ est de 20° à 70°, de préférence de 30° à 60°.

**3.** Dispositif suivant la revendication 1, caractérisé en ce que le creuset de vaporisation se déplace en direction du faisceau d'électrons ou du faisceau laser rencontrant sous un angle $\alpha$ la surface des matériaux inorganiques.

**4.** Dispositif suivant la revendication 1, caractérisé en ce que le faisceau d'électrons ou le faisceau laser est mobile de manière oscillant latéralement par rapport à l'axe longitudinal du creuset de vaporisation.

**5.** Dispositif suivant la revendication 1, caractérisé en ce que la surface des matériaux inorganiques dans le creuset de vaporisation forme un plan horizontal.

**6.** Procédé de revêtement d'une surface de substrat (18) avec une couche de revêtement de matériaux inorganiques par vaporisation sous vide de matériaux inorganiques (24) hors d'un creuset de vaporisation (22), le creuset de vaporisation (22) et le substrat (10) étant disposés dans une chambre à vide (30) et un canon à faisceau d'électrons ou canon à faisceau laser (26) disposé à proximité de la chambre à vide projetant un faisceau d'électrons ou un faisceau laser (27) sur les matériaux inorganiques (24) se trouvant dans le creuset de vaporisation (22), les matériaux inorganiques (24) vaporisant hors du creuset de vaporisation (22) et se précipitant sur la surface du substrat (10), caractérisé en ce que le faisceau d'électrons ou le faisceau laser (27) émis rencontre sous un angle α la surface des matériaux inorganiques (24), le faisceau d'électrons ou le faisceau laser (27) et la surface des matériaux inorganiques (24) formant un angle α de 10° à 80° et le creuset de vaporisation et le canon à faisceau d'électrons ou canon à faisceau laser sont déplacés l'un par rapport à l'autre vis-à-vis de leurs axes longitudinaux pendant la vaporisation et un surplomb (25) est formé dans le matériau inorganique (24) pendant la vaporisation du matériau inorganique (24) et il n'existe géométriquement aucun contact visuel entre le point d'impact (29) du faisceau d'électrons ou du faisceau laser (27) sur les matériaux inorganiques (24) et la surface du substrat (18).

7. Procédé suivant la revendication 6, caractérisé en ce que l'angle α vaut de 20° à 70° et en particulier de 30° à 60°.

8. Procédé suivant la revendication 6, caractérisé en ce que, pendant la vaporisation des matériaux inorganiques, le creuset de vaporisation (22) se déplace en direction du faisceau d'électrons ou du faisceau laser rencontrant sous un angle α la surface des matériaux inorganiques.

9. Procédé suivant la revendication 6, caractérisé en ce que, pendant la vaporisation des matériaux inorganiques, le faisceau d'électrons ou le faisceau laser est déplacé de manière oscillant latéralement par rapport à l'axe longitudinal du creuset de vaporisation.

10. Procédé suivant la revendication 6, caractérisé en ce que, pendant la vaporisation des matériaux inorganiques, le faisceau d'électrons ou le faisceau laser est déplacé de manière oscillant latéralement par rapport au creuset de vaporisation et le creuset de vaporisation et le canon à faisceau d'électrons ou canon à faisceau laser se déplacent avec une vitesse $V_T$ relativement l'un par rapport à l'autre et la vitesse $V_T$ est fonction de la grandeur de l'angle α, la vitesse $V_T$ étant exprimée avec la formule générale:

$$V_T = \frac{M}{t \times b} \times \frac{1}{\tan(\alpha) \times \Lambda \times \rho}$$

où $\Lambda$ est le surplomb en cm, $\rho$ la masse volumique du matériau inorganique, M la masse du matériau vaporisé, t l'unité de temps et b la largeur de balayage en cm du faisceau d'électrons ou du faisceau laser.

11. Procédé suivant la revendication 7, caractérisé en ce que la surface du matériau inorganique forme un plan horizontal et les matériaux inorganiques sont arrachés par vaporisation.

Fig. 1

Fig. 2

Fig. 3